# EUROPÄISCHE PATENTSCHRIFT

(11) **EP 0 653 137 B1**
(45) Veröffentlichungstag und Bekanntmachung des Hinweises auf die Patenterteilung: **30.10.1996**
(21) Anmeldenummer: 93914619.7
(22) Anmeldetag: 09.07.1993
(51) Int. Cl.: H04Q 1/02, H05K 7/16

(54) **MAGAZIN ZUR AUFNAHME VON TEILNEHMERANSCHLUSSBAUGRUPPEN**
RACK DESIGNED TO HOLD SUBSCRIBER-STATION ASSEMBLIES
CASIER POUR ENSEMBLES POSTES D'ABONNES

(30) Priorität: 30.07.1992 DE 9210238 U
(43) Veröffentlichungstag der Anmeldung: 17.05.1995
(73) Patentinhaber: SIEMENS AKTIENGESELLSCHAFT, 80333 München (DE)
(72) Erfinder: LANG, Hans, D-87789 Woringen (DE); HEITZIG, Claus-Peter, D-85235 Paffenhofen/Glonn (DE); STRECKER, Hans-Friedrich, D-80999 München (DE)
(86) Internationale Anmeldenummer: DE9300614
(87) Internationale Veröffentlichungsnummer: WO9404004

(56) Entgegenhaltungen:
- EP-A- 0 387 388
- CH-A- 623 698
- DE-B- 2 409 318
- DE-U- 9 210 238
- GB-A- 2 030 782
- US-A- 3 755 716

## Beschreibung

Die Erfindung bezieht sich auf ein Magazin zur Aufnahme von Trägerplatten für eine Vielzahl von steckbaren Anschlußbaugruppen für jeweils eine Teilnehmerleitung, wobei die Teilnehmerleitungen in Kabeln zusammengefaßt an das Magazin herangeführt und an Anschlußeinrichtungen der Trägerplatten angeschlossen sind, die im Magazin bewegbar gelagert sind.

Derartige Magazine werden z.B. von der Firma Northern Telecom in der digitalen Vermittlungstechnik eingesetzt. Durch die Zuordnung eines Teilnehmers zu jeweils einer Anschlußbaugruppe wird erreicht, daß z.B. im Reperaturfall kein anderer Teilnehmer vom Ziehen einer Baugruppe betroffen ist. Auf einer Trägerplatte sind z.B. 128 Teilnehmerbaugruppen gehalten. Die Trägerplatten sind auf dem Magazin zur Bedienseite herausziehbar gelagert. Die Teilnehmerleitungen sind in Kabeln zusammengefaßt, von denen jeweils eines an eine Trägerplatte unmittelbar angeschlossen ist, dessen Ende beim Ziehen der Trägerplatte mitbewegt wird. Die Kabelenden sind am Magazin schlaufenförmig ausgebildet, um die Trägerplatte genügend weit herausziehen zu können. Insbesondere für Breitbandübertragung sind die Kabel mit einem dichten Schirmmantel versehen, der die Beweglichkeit der Kabel beeinträchtigt. Die Reserveschlaufen müssen demzufolge entsprechend groß gehalten werden. Auf der Magazinrückseite ergeben sich somit Platzprobleme, die zur gegenseitigen Überdeckung und zu Behinderungen beim Ziehen der Trägerplatte führen.

Der Erfindung liegt die Aufgabe zugrunde, mit geringem Aufwand die Beweglichkeit der Trägerplatten zu erhöhen.

Diese Aufgabe wird durch die Erfindung gemäß Anspruch 1 gelöst. Beim Herausschwenken der Trägerplatten aus ihrer Ebene werden die Kabel nicht mehr verbogen, sondern lediglich auf einer hinreichenden Länge in sich verdreht, was weniger Kraftaufwand erfordert und die Kabel erheblich weniger deformiert.

Durch eine Weiterbildung der Erfindung nach Anspruch 2 ist es möglich, die Anzahl der Trägerplatten im Magazin bei gleichbleibend guter Zugänglichkeit zu verdoppeln. Dabei ist es vorteilhaft, die Drehachsen für die Trägerplatten an den einander gegenüberliegenden Seitenwänden des Magazins anzuordnen. Dadurch können gleiche Trägerplatten auf beiden Seiten verwendet werden.

Durch die Weiterbildung nach Anspruch 3 können die Teilnehmerleitungen aus dem Anschlußkabel problemlos auf der Rückseite der Trägerplatte an dieser angeschlossen werden. Durch die volle Schwenkbarkeit aller Trägerplatten sind diese sowohl auf der Vorder- als auch auf der Rückseite zugänglich.

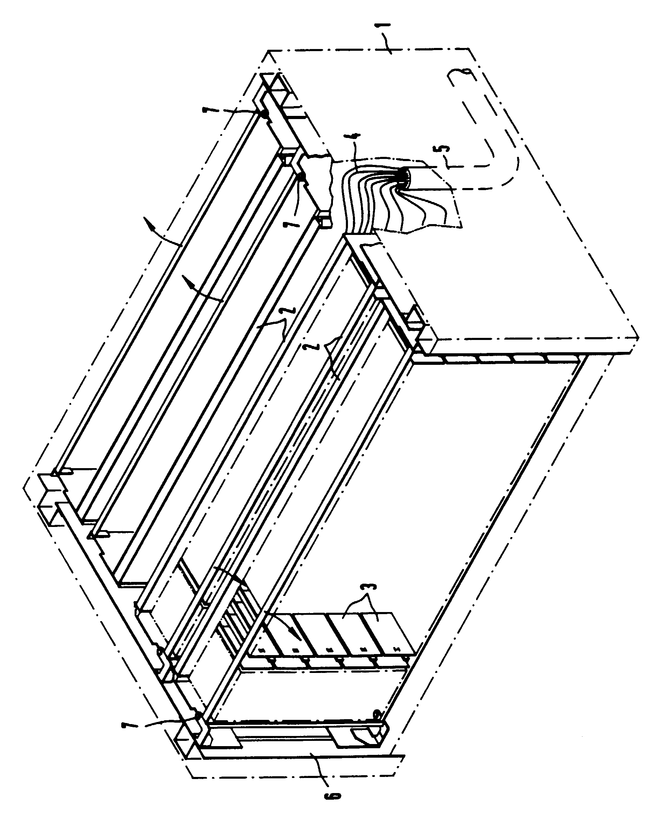

Im folgenden wird die Erfindung anhand eines in der Zeichnung dargestellten Ausführungsbeispieles näher erläutert. Die dargestellte Figur zeigt schematisiert in einer perspektivischen Darstellung ein Magazin zur Aufnahme von Trägerplatten 2 für eine Vielzahl von steckbaren Anschlußbaugruppen 3 für jeweils eine Teilnehmerleitung 4. Die Teilnehmerleitungen 4 sind für jeweils eine Trägerplatte in einem Kabel 5 zusammengefaßt, das entlang einer Seitenwand 6 des Magazins an die Trägerplatte 2 herangeführt ist.

Die Anschlußbaugruppen 3 sind in einer Vielzahl von Zeilen und Reihen an den Trägerplatten 2 senkrecht zu diesen steckbar gehalten und über Leiterbahnen der Trägerplatte 2 mit den Teilnehmerleitungen 4 verbunden, die ihrerseits auf der den Anschlußbaugruppen 3 abgewandten Rückseite der Trägerplatte 2 an dieser angeschlossen sind.

An den Seitenwänden 5 sind Scharniere 7 befestigt, in denen die Trägerplatten 2 um eine senkrechte Achse schwenkbar gelagert sind. Diese Scharniere 7 befinden sich in der Ebene einer der Stirnseiten der Trägerplatten 2, so daß diese soweit aus dem Magazin herausschwenkbar sind, daß sie von beiden Seiten her zugänglich sind. Im Falle eines Ausfalls einer Anschlußbaugruppe 3 kann diese herausgezogen werden, ohne daß andere Teilnehmer davon betroffen sind.

Die Enden der Kabel 5 erstrecken sich in der Nähe der Scharniere 7 in deren Achsrichtung und werden beim Herausschwenken der Trägerplatten 2 mit geringem Verformungsgrad in sich verdreht.

## Patentansprüche

1. Magazin (1) zur Aufnahme von Trägerplatten (2) für eine Vielzahl von steckbaren Anschlußbaugruppen (3) für jeweils eine Teilnehmerleitung (4), wobei die Teilnehmerleitungen (4) in Kabeln (5) zusammengefaßt an das Magazin (1) herangeführt und an die Trägerplatten (2) angeschlossen sind, die in dem Magazin (1) bewegbar gelagert sind,
**dadurch gekennzeichnet,**
daß die Trägerplatten (2) in mehreren zur Bedienungsseite parallelen Ebenen angeordnet sind,
daß zumindest die äußeren Trägerplatten (2) am Magazin (1) schwenkbar gelagert sind,
daß die Scharniere (7) auf einer Schmalseite der Trägerplatten (2) angeordnet sind, und
daß sich die Endabschnitte der Kabel (5) in unmittelbarer Nähe der Scharniere (7) der Trägerplatte (2) parallel zu deren Schwenkachse erstrecken.

2. Magazin nach Anspruch 1,
**dadurch gekennzeichnet,**
daß die Trägerplatten (2) sowohl nach der Bedienungsseite des Magazins (1) als auch nach der gegenüberliegenden Rückseite des Magazins (1) hin ausschwenkbar gelagert sind.

3. Magazin nach Anspruch 2,
**dadurch gekennzeichnet,**
daß die Trägerplatten (2) auf einer Seite mit den Anschlußbaugruppen (3) bestückt sind,
daß die Teilnehmerleitungen (4) auf die Gegenseite der Trägerplatten (2) an dieser angeschlossen sind und daß sämtliche Trägerplatten (2) schwenkbar gelagert sind.

## Claims

1. Rack (1) for the accommodation of mounting boards (2) for a large number of plug-in line modules (3) for in each case one subscriber line (4), the subscriber lines (4) being passed to the rack (1) combined in cables (5) and being connected to the mounting boards (2), which are mounted in the rack (1) such that they can move,
characterized in that
the mounting boards (2) are arranged in a plurality of planes which are parallel to the operating side,
in that at least the outer mounting boards (2) are mounted on the rack (1) such that they can pivot,
in that the hinges (7) are arranged on a narrow side of the mounting boards (2), and
in that the end sections of the cable (5) extend in the immediate vicinity of the hinges (7) of the mounting board (2), parallel to its pivoting axis.

2. Rack according to Claim 1,
characterized in that
the mounting boards (2) are mounted such that they can pivot out both towards the operating side of the rack (1) and towards the opposite rear side of the rack (1).

3. Rack according to Claim 2,
characterized in that
the mounting boards (2) are fitted with the line modules (3) on one side,
in that the subscriber lines (4) are connected to the mounting boards (2) on their opposite side, and
in that all the mounting boards (2) are mounted such that they can pivot.

## Revendications

1. Magasin (1) de réception de plaques (2) porteuses d'un grand nombre de modules (3) de raccordement enfichables destinés chacun à une ligne (4) d'abonné, les lignes (4) d'abonné étant réunies dans des câble (5), amenées au magasin (1) et raccordées aux plaques (2) porteuses qui sont montées mobiles dans le magasin (1), caractérisé en ce que les plaques (2) porteuses sont montées dans plusieurs plans parallèles à la face de service, en ce qu'au moins les plaques (2) porteuses extérieures sont montées basculantes sur le magasin (1), en ce que les charnières (7) sont montées sur un petit côté des plaques (2) porteuses, et en ce que les tronçons d'extrémité des câbles (5) s'étendent à proximité immédiate des charnières (7) de la plaque (2) porteuse, parallèlement à son axe de basculement.

2. Magasin suivant la revendication 1, caractérisé en ce que les plaques (2) porteuses sont montées basculantes totalement aussi bien vers la face de service du magasin (1) que vers la face arrière opposée du magasin (1).

3. Magasin suivant la revendication 2, caractérisé en ce que les plaques (2) porteuses sont munies d'un côté des modules (3) de raccordement, en ce que les lignes (4) de raccordement sont raccordées aux plaques (2) porteuses, à leur côté opposé, et en ce que toutes les plaques (2) porteuses sont montées basculantes.
